(19) Europäisches Patentamt
European Patent Office
Office européen des brevets

(11) EP 1 233 490 A2

(12) EUROPEAN PATENT APPLICATION

(43) Date of publication:
**21.08.2002 Bulletin 2002/34**

(51) Int Cl.[7]: **H01S 5/14**, H01S 3/067, H01S 3/094

(21) Application number: **02001930.3**

(22) Date of filing: **31.01.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **02.02.2001 US 776226**
**10.04.2001 JP 2001111664**

(71) Applicant: **THE FURUKAWA ELECTRIC CO., LTD.**
**Tokyo (JP)**

(72) Inventors:
- **Yoshida, Junji**
  **Chiyoda-ku, Tokyo (JP)**
- **Tsukiji, Naoki**
  **Chiyoda-ku, Tokyo (JP)**
- **Aikiyo, Takeshi**
  **Chiyoda-ku, Tokyo (JP)**
- **Koyanagi, Satoshi**
  **Chiyoda-ku, Tokyo (JP)**

(74) Representative: **Modiano, Guido, Dr.-Ing. et al**
**Modiano, Josif, Pisanty & Staub,**
**Baaderstrasse 3**
**80469 München (DE)**

(54) **Semiconductor laser module and fiber amplifier and optical communications system using the same**

(57) Disclosed is a semiconductor laser module which is advantageous as a pumping source for Raman amplification because of its high optical output and excellent wavelength stability. The module comprises a Fabry-Pérot semiconductor laser device to which a fiber Bragg grating having a wavelength selectivity and showing a specific reflectivity with respect to a specific wavelength is optically coupled, wherein given that a cavity length of the semiconductor laser device is L (μm), a reflection bandwidth of the fiber Bragg grating is $\Delta\lambda$ (nm) and a reflectivity of said front facet is $R_1$ (%) and a peak reflectivity of said optical feedback part is $R_2$ (%), following equations are satisfied among L, $R_1$ and $R_2$

$$1000\ \mu m \leq L \leq 3500\ \mu m,$$

$$0.01\% \leq R_1 + c^2R_2 \leq 4\% \text{ and}$$

$$R_1/R_2 \leq 0.8$$

where c represents a coupling efficiency between the semiconductor laser device and the fiber Bragg grating. It is preferable that $0.2\ nm \leq \Delta\lambda \leq 3\ nm$ should be satisfied.

FIG. 1

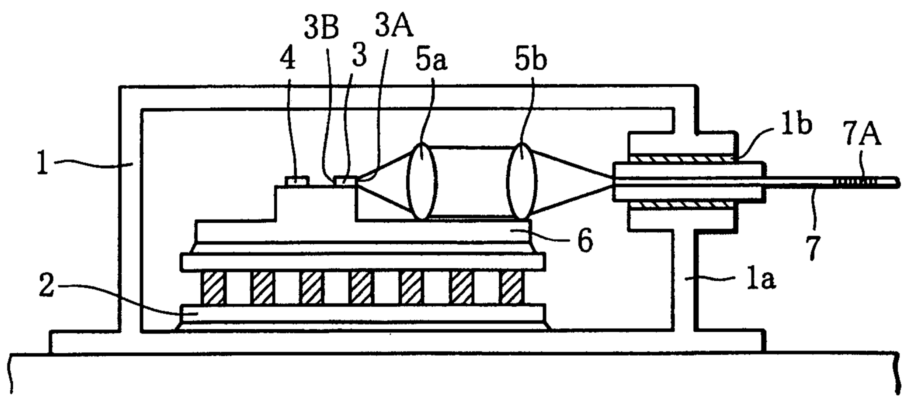


EP 1 233 490 A2

## Description

## BACKGROUND

### Field of the Invention

The present invention relates to a semiconductor laser module designed as a pumping source for an optical communications system. More particularly, the invention relates to a complex cavity type semiconductor laser module which has a Fabry-Pérot semiconductor laser device optically coupled to an optical feedback part, such as a fiber Bragg grating (FBG), a dielectric multilayered filter or a distribution Bragg reflector (DBR). This module is useful as a laser module which has a characteristic of emitting a pumping laser beam with a high optical output, a laser module which has a characteristic of emitting a pumping laser beam with an optical stability or a pumping source which has a suppressed occurrence of kinks and is used in, for example, a wavelength division multiplexing system that employs a Raman amplification system.

### Prior Art

Wavelength division multiplexing (WDM) communications systems have been developed as optical communications systems that transmit a plurality of signal lights. In such a system, optical amplifiers are arranged at predetermined locations in an optical path and a laser module incorporating a Fabry-Pérot semiconductor laser device is connected to each optical amplifier. As a pumping laser beam having a predetermined oscillation spectrum is input to each optical amplifier from the laser module, the optical signal that has been attenuated in the transmission through the upstream path is amplified and the optically amplified signal light is transmitted again to the downstream path.

At present, an Er-doped fiber amplifier (EDFA) is widely used as an optical amplifier in that system.

The EDFA executes optical amplification of a stimulated emission type. That is, Er ions are excited by a pumping laser beam which is input from the laser module and a flat gain wavelength bandwidth defined at the energy level appears in the EDFA. The signal light of the wavelength that is included in the flat gain wavelength bandwidth is optically amplified.

In the EDFA, the practical gain wavelength bandwidth which is concerned with the optical amplification of signal light or the flat gain wavelength bandwidth is about 1530 to 1610 nm. That is, in case where optical signal amplified in the system is limited to the one whose wavelength lies within the aforementioned bandwidth.

The Raman amplification system also has been known as an optical amplification system for signal light. This amplification system has a characteristic such that signal light having a wider bandwidth can be optically amplified as compared with the case of the EDFA. Therefore, there is a growing expectation of adapting the Raman amplification system to optical communications systems.

The Raman amplification system is an optical amplification system which employs such a phenomenon that as a laser beam having an extremely high optical output (pumping laser beam) is input to an optical fiber, stimulated Raman scattering occurs in the optical fiber, giving a gain at a frequency smaller by 13 THz than the wavelength of the pumping laser beam (on the longer wavelength side by approximately 100 nm), and as signal light of a wavelength included in the wavelength bandwidth that provides the gain is input to the optical fiber in such a pumped state, the signal light is optically amplified.

Unlike the EDFA system, the Raman amplification system can be directly adapted to existing optical paths because the system can use an optical fiber (optical path) itself as an amplification medium without using a special optical fiber. That is, unlike the EDFA system, the Raman amplification system can reduce relay points in the entire optical paths. This can simplify the maintenance and control of the entire system and reduce the construction cost and maintenance cost of the entire system while improving the reliability of the entire system.

In principle, the Raman amplification system can optically amplify signal light of an arbitrary wavelength bandwidth because the system can provide a gain at a frequency smaller by 13 THz than the wavelength of a pumping laser beam of an arbitrary wavelength by varying the wavelength of a pumping laser beam to be input to an optical fiber, i.e., by inputting the pumping laser beam to the optical fiber.

In case where the Raman amplification system is adapted to the WDM communications system, therefore, it is possible to increase the number of channels of signal lights.

In the case of the Raman amplification system, the gain of an optical fiber has a certain wavelength distribution. In case where a pumping laser beam shows an oscillation spectrum having the center wavelength at 1430 nm, for example, the gain that is realized in the Raman amplification has a peak in the vicinity of the wavelength of 1530 nm and has an asymmetrical gain distribution with a margin of about 20 nm around the peak wavelength.

To realize a flat gain over a wide wavelength bandwidth, therefore, the Raman amplification system multiplexes a plurality of pumping laser beams whose center wavelengths and optical outputs have been adjusted and inputs the multiplexed laser beam to an optical fiber.

Specifically, as a plurality of pumping laser beams whose center wavelengths differ from one another are output from a plurality of laser modules and are multiplexed by a wavelength multiplexing coupler and the wavelength-multiplexed single pumping laser beam is input to the optical fiber, the gains of the individual pumping laser beams are made to continuously overlap one another on the long wavelength side of about 100 nm, thereby realizing a gain of a wide wavelength bandwidth on the whole.

In case where a pumping laser beam of, for example, 100 mW is input to an existing communications optical fiber from a laser module, the obtained Raman gain is about 3 dB, which is too small to adequately realize optical amplification of signal light.

In view of the above, the Raman amplification system is demanded to generally use a pumping laser beam with a high optical output of 200 mW or greater, preferably 300 mW or greater and more preferably 400 mW to 1 W, in order to acquire a gain which can ensure optical amplification of signal light.

In general, therefore, an optical output with the desired intensity is acquired by multiplexing laser beams from a plurality of laser modules and inputting the multiplexed laser beam to an optical fiber as a pumping laser beam.

As apparent from the above, the adaptation of the Raman amplification system to the WDM communications system has several advantages. However, laser modules as a pumping source in the Raman amplification system have many problems to solve.

The essential characteristics of which a Raman amplification pumping source are demanded will be discussed as follows.

(1) First, a laser module which is a pumping source should emit a very high optical output. Specifically, as mentioned earlier, an optical output of 200 mW or greater should be emitted. A general system multiplexes laser beams from a plurality of laser modules. This requires not only that the multiplexed optical output as a whole should become high power but also that the individual laser modules should emit high outputs.

(2) When the center wavelength of the pumping laser beam from a laser module varies, the wavelength bandwidth of the Raman gain varies. As a result, it causes a mismatch between the wavelength bandwidth of the Raman gain and the wavelength of signal light to be optically amplified. This makes it difficult to realize the intended optical amplification. In the WDM communications system, particularly, when such a gain variation occurs, the flatness of the gain wavelength bandwidth is impaired. This makes it difficult to realize stable optical amplification of signal light over a wide bandwidth.

The laser module is therefore demanded of an excellent wavelength stability to emit a pumping laser beam with a small variation in center wavelength. Specifically, the demanded laser module should be able to emit a pumping laser beam whose variation in center wavelength lies within ± 1 nm under the driving conditions of the ambient temperature of 0 to 70°C and the driving current of 0 to 1 A.

(3) In case where the intensity of the pumping laser beam varies (fluctuates) in the Raman amplification system, the Raman gain fluctuates, lowering the signal to noise ratio (S/N ratio) of signal light. In this respect, the pumping laser beam from the laser module should be noiseless.

There are three pumping systems for Raman amplification: forward pumping system, backward pumping system and bidirectional pumping system. At present, the backward pumping system is a mainstream for the following reason. In the case of the forward pumping system in which a low-power signal light and a high-power pumping laser beam travel in the same direction, the signal light is significantly affected by the variation (fluctuation) of the intensity of the pumping laser beam. This brings about a difficulty in the system reliability.

Even if a laser module is used as a forward pumping source, therefore, there still is a demand for development of a laser module which does not cause a variation in the intensity of a pumping laser beam and has an excellent optical stability.

(4) Raman amplification is realized when the polarization direction of signal light matches with the polarization direction of the pumping laser beam. That is, Raman amplification has a polarization dependency. To achieve Raman amplification, therefore, it is necessary to reduce the influence of a difference between the polarization direction of signal light and the polarization direction of the pumping laser beam.

In this case, if the backward pumping system is used for Raman amplification, the polarization direction of signal light becomes at random during propagation so that the polarization dependency is curbed.

As the forward pumping system makes the polarization dependency of Raman amplification stronger, however, the system requires that the pumping laser beam in use should reduce the polarization dependency of Raman amplification. This makes it necessary to perform depolarization on the pumping laser beam to thereby reduce the degree of polarization (DOP).

In case where a plurality of laser modules are optically coupled to a wavelength multiplexing coupler to acquire a high-power pumping laser beam, is required as follows.

The ratio of the power of a laser beam from each laser module which lies in the pass band of the wavelength multiplexing coupler to the entire power should be equal to or greater than a predetermined value, specifically, for example, 90% or higher, and the ratio should be stable while the laser module is driven.

In consideration of the fact that the pumping laser beam from the laser module has an oscillation spectrum formed by plural Fabry-Pérot modes, the degree of the width of the oscillation spectrum is an important factor to fulfill the requirement.

If the width of the oscillation spectrum becomes too wide, the number of Fabry-Pérot modes present in the width of the oscillation spectrum becomes large, so that at the time of driving the laser module, the power distribution among the Fabry-Pérot modes varies to the level at which noise or a variation in gain cannot be neglected. In addition, the multiplexing loss at the time of multiplexing the wavelengths by the wavelength multiplexing coupler becomes large. If the width of the oscillation spectrum becomes too narrow, on the other hand, it becomes difficult to reduce the polarization dependency of the Raman gain and a kink occurs in the current v.s. optical output characteristic of the laser module, thus limiting the optical output of the laser module.

The "width of the oscillation spectrum" mentioned here is a wavelength bandwidth that provides a spectral intensity lower by 3 dB than a peak value in the waveform of the pumping laser beam from the laser module.

In view of the above, the width of the oscillation spectrum should be 3 nm or narrower, preferably 2 nm or narrower. Thus, the pumping laser beam is required to have smaller degree of polarization and the width of the oscillation spectrum of 3 nm or narrower. It is known that the degree of polarization of a multimode pumping laser beam which has at least three Fabry-Pérot modes, preferably four to five, in the width of the oscillation spectrum becomes smaller.

Therefore, the laser module that is used when the Raman amplification system is adapted to the WDM communications system should meet the requirement that the width of the oscillation spectrum is 3 nm or narrower and a multimode pumping laser beam which has at least three Fabry-Pérot modes in the width of the oscillation spectrum should be emitted.

The use of a multimode pumping laser beam is advantageous in making it difficult to cause a reduction in the pumping efficiency based on the stimulated Brillouin scattering which occurs when a high optical output concentrates in a narrow wavelength bandwidth. In this case, the preferable spacing between the Fabry-Pérot modes of the pumping laser beam is said to be 0.1 nm or larger.

## OBJECT AND SUMMARY OF THE INVENTION

Accordingly, it is an object of the present invention to provide a semiconductor laser module which emits a laser beam having an extremely high optical output and an excellent wavelength stability.

It is another object of the present invention to provide a semiconductor laser module which is useful as a pumping source in the WDM communications system to which the Raman amplification system is adapted.

It is a further object of the present invention to provide a fiber amplifier which uses the semiconductor laser module and an optical communications system which uses the fiber amplifier.

To achieve the above object, according to one aspect of the present invention, there is provided a following semiconductor laser module (module A).

The module A comprises:

a Fabry-Pérot semiconductor laser device to a front facet of which an optical feedback part having a wavelength selectivity and showing a specific reflectivity with respect to a specific wavelength is optically coupled,

wherein given that a cavity length of the semiconductor laser device is L (unit: μm), a reflectivity of the front facet is $R_1$ (%) and a peak reflectivity of the optical feedback part is $R_2$ (%), following equations are satisfied among L, $R_1$ and $R_2$

$$1000\ \mu m \leq L \leq 3500\ \mu m \qquad (1),$$

and

$$0.01\% \leq R_1 + c^2 R_2 \leq 4\% \qquad (2)$$

where c represents a coupling efficiency between the semiconductor laser device and the optical feedback part.

A preferred module A satisfies the relationships represented by the following expressions:

$$1000\ \mu m \leq L \leq 3500\ \mu m \quad (1),$$

and

$$0.1\% \leq R_1 + c^2R_2 \leq 4\% \quad (2').$$

According to another aspect of the present invention, there is provided a following semiconductor laser module (module B).

The module B comprises:

a Fabry-Pérot semiconductor laser device to a front facet of which an optical feedback part having a wavelength selectivity and showing a specific reflectivity with respect to a specific wavelength is optically coupled,

wherein given that a cavity length of the semiconductor laser device is L (unit: µm), a reflectivity of the front facet is $R_1$ (%) and a peak reflectivity of the optical feedback part is $R_2$ (%), following equations are satisfied among L, $R_1$ and $R_2$

$$1000\ \mu m \leq L \leq 3500\ \mu m \quad (1),$$

and

$$R_1/R_2 \leq 0.8 \quad (3).$$

According to a further aspect of the present invention, there is provided a following semiconductor laser module (module C).

The module C comprises:

a Fabry-Pérot semiconductor laser device to a front facet of which an optical feedback part having a wavelength selectivity and showing a specific reflectivity with respect to a specific wavelength is optically coupled,

wherein given that a cavity length of the semiconductor laser device is L (unit: µm), a reflectivity of the front facet is $R_1$ (%) and a peak reflectivity of the optical feedback part is $R_2$ (%), following equations are satisfied among L, $R_1$ and $R_2$

$$1000\ \mu m \leq L \leq 3500\ \mu m \quad (1),$$

$$0.01\% \leq R_1 + c^2R_2 \leq 4\% \quad (2),$$

and

$$R_1/R_2 \leq 0.8 \quad (3)$$

where c represents a coupling efficiency between the semiconductor laser device and the optical feedback part.

A preferred module C satisfies the relationships represented by the following expressions:

$$1000\ \mu m \leq L \leq 3500\ \mu m \quad (1),$$

$$0.1\% \leq R_1 + c^2R_2 \leq 4\% \quad (2'),$$

and

$$R_1/R_2 \leq 0.8 \quad (3).$$

Further, with respect to all of the modules A, B and C according to the present invention, the optical feedback part may be designed to have a reflection bandwidth $\Delta\lambda$ (nm) meeting the following condition:

$$0.2\ \text{nm} \leq \Delta\lambda \leq 3\ \text{nm} \quad (4),$$

thus providing as a more suitable optical module.

According to the present invention, there are provided a fiber amplifier which uses one of the modules A, B and C as a pumping source and an optical communications system which has the fiber amplifier and one of the modules A, B and C.

## BRIEF DESCRIPTION OF THE DRAWINGS

Fig. 1 is a schematic diagram showing one example of a laser module according to the present invention;
Fig. 2 is an exemplary diagram illustrating the state in which a semiconductor laser device and a fiber Bragg grating which are essential components of the laser module are optically coupled to each other;
Fig. 3 is a cross-sectional view along the line III-III in Fig. 2;
Fig. 4 is a graph showing the relationship among the cavity length (L) of the semiconductor laser device, the reflectivity ($R_1$) of a front facet and a maximum optical output (Pmax);
Fig. 5 is a graph showing the relationship among the cavity length (L) of the semiconductor laser device, the reflectivity ($R_1$) of the front facet and the maximum optical output (Pmax);
Fig. 6 is an explanatory diagram for explaining the power in band of the laser module;
Fig. 7 is a graph showing the results of Experiment II;
Fig. 8 is a graph showing the relationship between the reflectivity ($R_1$) of the front facet of a semiconductor laser device in a laser module C of the present invention and the peak reflectivity ($R_2$) of a fiber Bragg grating; and
Fig. 9 is a graph showing the current v.s. optical output characteristics of Example 1 and Example 2.

## DETAILED DESCRIPTION

To begin with, the thought process to develop a module according to the present invention will be discussed.

In the process of devoting to study to achieve the objects, the present inventors paid attention to the fact that, as already disclosed in WO 00/46893, a Fabry-Pérot semiconductor laser device having a cavity length set to 1000 μm or greater could provide a high optical output if optimized by reducing the reflectivity of the front facet (output facet). To aim at producing a semiconductor laser module for Raman amplification that is demanded of a high optical output of 200 mW or greater, the present inventors reached the conclusion that the aforementioned Fabry-Pérot semiconductor laser device with a long cavity length should be used as a laser device (light source) to be incorporated in the semiconductor laser module.

The results of measuring the maximum optical outputs of a laser device by changing the cavity length and the reflectivity of the front facet showed a certain correlation among the cavity length, the front facet reflectivity and the maximum optical output.

With regard to the achievement of the wavelength stability of a pumping laser beam, the present inventors paid attention to a method of forming an optical coupling system of a complex cavity type by optically coupling the laser device and a fiber Bragg grating. This method has been known as a method of fixing the oscillation wavelength of a Fabry-Pérot semiconductor laser device.

In the complex cavity type optical coupling system, as the driving current or the ambient temperature varies, the oscillation spectrum of the laser device changes, resulting in a change in the center wavelength of the gain wavelength bandwidth to be obtained. Because the mirror loss characteristic is lower at the vicinity of the center wavelength of the reflection bandwidth of the fiber Bragg grating, however, the oscillation spectrum of the laser device is pulled into the vicinity of the center wavelength of the reflection bandwidth of the fiber Bragg grating (pull-in of the oscillation spectrum of the laser device) so that the wavelength bandwidth of the laser beam emitted from the optical coupling system or the pumping laser beam is fixed to the vicinity of the center wavelength of the reflection bandwidth of the fiber Bragg grating.

Studying the pull-in conditions of the oscillation spectrum of a laser device in the complex cavity type optical coupling system constructed by changing the reflectivity of the front facet of the laser device and the reflectivity of the fiber Bragg grating, the inventors discovered that it was necessary to set the relation between the reflectivity of the front facet of the laser device and the reflectivity of the fiber Bragg grating to the aforementioned relation in order to ensure the pull-in operation. The inventors succeeded to quantify the essential conditions for wavelength stability in terms of the equations (1), (2), (3) and (4) and combinations thereof and developed the modules of the present invention based on the discovery.

In the modules A, B and C, the equations (1) and (2) are essential conditions for the complex cavity type optical coupling system to provide a high optical output. The equation (3) means the essential condition for pulling the oscillation spectrum of the laser device into the vicinity of the center wavelength of the reflection bandwidth of the optical feedback part. As will be discussed later, the equation (4) means the essential condition for suppressing the occurrence of a kink attributable to longitudinal mode hopping when the module is driven.

For the present, therefore, the module A functions as a complex cavity type pumping source which emits a high optical output.

For the present, therefore, the module B functions as a complex cavity type pumping source which ensures at least the wavelength stability while being able to emit a high optical output.

The module C that satisfies the equations (1), (2) and (3) surely has both characteristics of providing a high optical output and an excellent wavelength stability, and is very useful as a pumping source of the Raman amplification system.

Any of the modules A, B and C that fulfill the equation (4) demonstrates its own function mentioned above as well as the suppressed occurrence of a kink.

Those modules can have any optical feedback part as long as the optical feedback part has a wavelength selectivity and shows a specific reflectivity with respect to a specific wavelength. For example, a fiber Bragg grating, a dielectric multilayered filter and a distribution Bragg reflector (DBR) are available as the optical feedback part. Of those three, the fiber Bragg grating is suitable.

The basic structure of the modules A, B and C of the present invention is exemplified in Fig. 1. The exemplified module uses a fiber Bragg grating as its optical feedback part.

In Fig. 1, a package 1 houses a Peltier module 2 and a substrate 6 on which a Fabry-Pérot semiconductor laser device 3 with suppressed high-order transverse modes, as discussed later, a thermistor 4 and lenses 5a and 5b are secured is fixed on the Peltier module 2. An optical fiber 7 having a fiber Bragg grating 7A to be discussed later is secured into a through hole 1b formed in a side wall 1a of the package 1.

In the modules, as a laser beam which is emitted from a front facet 3A of the laser device 3 and has an oscillation spectrum formed by a plurality of Fabry-Pérot modes passes the two lenses 5a and 5b, the laser beam is condensed and input to the end face of the optical fiber 7. The laser beam is then waveguided through the core of the optical fiber 7 and of the waveguided laser beam, the Fabry-Pérot mode light that is included in the reflection bandwidth ($\Delta\lambda$) of the fiber Bragg grating is reflected at the fiber Bragg grating 7A and returns to the laser device as a reflection light of a specific wavelength. Each module is of a complex cavity type in which resonance between the front facet 3A and a rear facet 3B of the laser device 3 and resonance between the rear facet 3B of the laser device 3 and the fiber Bragg grating 7A are compounded.

It is possible to use a single lens and/or a lensed fiber in place of the lenses 5a and 5b.

According to the modules of the present invention, the laser beam emitted from the laser device 3 carries out a sequence of resonant operations in which resonance in the cavity of the laser device 3 and resonance between the rear facet 3B and the fiber Bragg grating 7A are compounded, then becomes a high-power pumping laser beam and is transmitted to a predetermined place in the optical path from the optical fiber 7.

At the time such an operation takes place, the driving current introduced in the laser device 3 heats up the laser device, raising the device temperature. When the device temperature rises, the center wavelength and the spectral intensity in the oscillation spectrum of the emitted laser beam vary. To prevent this shortcoming, each module of the present invention measures the device temperature with the thermistor 4 located near the laser device 3 and the laser device 3 is adequately cooled by regulating the operational current of the Peltier module 2 under the control of an external control circuit (not shown) using the measured value, so that the temperature of the laser device 3 is set constant.

In the modules with the structure shown in Fig. 1, the equations (1) and (2) are met for the module A, the equations (1) and (3) are met for the module B, and the equations (1) through (3) are met for the module C at the same time.

Any one of the modules can suppress the generation of a kink caused by longitudinal mode hopping by setting the reflection bandwidth $\Delta\lambda$ of the fiber Bragg grating to 3 nm or narrower.

The optical coupling of the semiconductor laser device 3 and the fiber Bragg grating in the module in Fig. 1 from which the other components are omitted is illustrated as an exemplary diagram in Fig. 2.

In Fig. 2, the optical fiber 7 having the fiber Bragg grating 7A formed therein is arranged facing the front facet 3A of the semiconductor laser device 3, thereby constituting the optical coupling system of the laser device 3 and the fiber Bragg grating 7A.

The meanings of the equations (1) through (4) will be discussed with reference to the abovementioned optical coupling system.

First, a description will be given of the equations (1) and (2) that are essential conditions for the optical coupling system to provide a high optical output.

The laser device 3 is the light emission source of the optical coupling system. If emission of a high optical output from the optical coupling system is achieved, it means that the laser device 3 as the light emission source provides a high optical output. In this respect, first it is necessary to look for a condition for realizing the emission of a high optical output from the laser device 3.

The semiconductor laser device 3 in the optical coupling system is of a Fabry-Pérot type one example of which is depicted in Fig. 2 and a cross-sectional view of Fig. 3 along the line III-III in Fig. 2.

The laser device 3 has a lower cladding layer 12, a lower GRIN-SCH layer 13, an active layer 14 with a quantum well structure and an upper GRIN-SCH layer 15 deposited in order on a substrate 11 of a predetermined semiconductor by a known epitaxial growth method, such as a metal organic vapor phase epitaxial growth method, liquid phase epitaxial method, molecular beam epitaxy, gas source molecular beam epitaxy or chemical beam epitaxy. An upper cladding layer 16 and a cap layer 17 are laminated on the upper GRIN-SCH layer 15. An upper electrode 18 is formed on the cap layer 17 and a lower electrode 19 is formed at the back of the substrate 11.

A p-type layer 21 and an n-type layer 22 are laminated on the sides of the lower cladding layer 12, the lower GRIN-SCH layer 13, the active layer 14 and the upper GRIN-SCH layer 15 in the named order.

And the active layer 14 is surrounded by current blocking layer, thereby forming a realizing current ration and suppressing high order traverse modes.

The laser device 3 is fabricated by forming a laminated structure of a semiconductor material by a predetermined epitaxial growth method, cleaving the structure to a predetermined cavity length L, depositing a low-reflectivity film on one cleaved face to form the front facet 3A having a peak reflectivity $R_1$ (%) and depositing a high-reflectivity film on the other cleaved face to form the rear facet 3B.

The semiconductor material for the laser device 3 is adequately selected in consideration of the relation between the material property and the designated wavelength (center wavelength) of the pumping laser beam that is used in an optical amplifier for signal light. In case of acquiring a pumping laser beam having the designated wavelength of 1300 to 1600 nm, for example, the laser device 3 can be fabricated by using a material selected from GaInAs, GaInAsP, AlGaInAs and GaInNAs material systems.

In such a laser device, generally speaking, the longer the cavity length L is, the lower the series resistance of the laser device when driven current becomes the greater and the greater the heat dissipation area becomes. The heat saturation phenomenon of the optical output is restrained and a variation in the center wavelength of the oscillation spectrum is restrained too. This makes it possible to increase the driving current of the laser device, thereby ensuring a high optical output as well as the stability of the center wavelength of the oscillation spectrum.

However, merely making the cavity length L longer lowers the mirror loss in the front facet 3A and the rear facet 3B and increases the influence of the inner loss of the cavity. This results in a reduction in an external quantum efficiency of the laser device 3.

In view of the above, the present inventors conducted the following experiment I and studied the relationship among the cavity length L, the peak reflectivity $R_1$ of the front facet and the optical output.

Experiment I

First, the inventors fabricated various laser devices that have a layered structure shown in Fig. 3 or a lattice mismatched quantum well active region having both the lower GRIN-SCH layer 13 and the upper GRIN-SCH layer 15 formed of non-doped GaInAsP and having the active layer 14 formed of GaInAsP, by setting the reflectivity of the rear facet 3B constant to 95% and changing the cavity length L and the peak reflectivity $R_1$ of the front facet 3A. The laser devices were driven and the maximum optical outputs (Pmax: mW) of the laser devices were measured. The measuring results are illustrated in Figs. 4 and 5.

The following are apparent from Figs. 4 and 5.

1) As apparent from Fig. 4, as the cavity length L is made longer beyond 1000 μm with the peak reflectivity $R_1$ of the front facet 3A set constant, the value Pmax of each laser device increases as the cavity length L gets longer when the value of $R_1$ is equal to or less than 4%.

2) As apparent from Fig. 5, as reflectivity $R_1$ of the front facet 3A is increased with the cavity length L set constant, the value Pmax of each laser device changes in such a curve as to have a peak at a certain $R_1$. What is more, as the cavity length L becomes longer, the value Pmax becomes greater but the peak of the value Pmax in each curve varies in such a way as to become larger as the value of $R_1$ gets smaller.

3) In view of the above, to increase the value Pmax of the laser device, it is effective to make the cavity length L longer and make the reflectivity $R_1$ of the front facet 3A smaller at the same time as apparent from Fig. 5.

4) In consideration of the fact that the demanded optical output of the pumping source in the Raman amplification system is 200 mW or higher, it is apparent from Fig. 5 that in case of using the laser device as the pumping source, the cavity length L should be set equal to or greater than 1000 μm and the reflectivity $R_1$ of the front facet 3A should be set within a range of 0.01 to 4%, more preferably 0.1 to 4%.

If the cavity length L is set too long, however, the influence of the inner loss of the cavity increases, as mentioned above, causing a reduction in mirror loss. This not only reduces the external quantum efficiency but causes cracking or damage in the cavity during the formation of a chip in the process of manufacture of the laser device 3, which leads to a lower manufacturing yield. In view of the above, the upper limit of the cavity length of the laser device 3 is set to 3500 μm.

Considering those circumstances, in case where the laser device that emits a high optical output of 200 mW or higher, the cavity length L should be 1000 to 3500 μm, preferably be 3200 μm or shorter where the longitudinal mode spacing is 0.1 mm or longer, from the viewpoint of preventing stimulated Brillouin scattering. The reflectivity of the front facet should be set to 0.01 to 4%, preferably 0.1 to 4%.

The module shown in Fig. 1 is a complex cavity type having the laser device 3 optically coupled to the fiber Bragg grating 7A. Unlike the laser device used in the experiment I which carries out resonance between one front facet and one rear facet, the module has resonance in the laser device 3 compounded with resonance between the fiber Bragg grating 7A and the rear facet 3B of the laser device 3, resulting in the emission of the pumping laser beam from the optical fiber 7.

Therefore, the module can be assumed as a laser device which has a single cavity structure. In this case, the reflectivity of the rear facet of the assumed laser device is equivalent to the reflectivity of the rear facet 3B of the actual laser device 3. The assumed laser device does not actually have a front facet. If the assumed laser device had the front facet, however, the reflectivity of the front facet can be effectively expressed by an equation $R_1 + c^2R_2$ where $R_1$ is the reflectivity of the front facet 3A of the real laser device 3 and $R_2$ is the peak reflectivity of the fiber Bragg grating 7A.

By adapting the discovery made in the experiment I to the assumed laser device or the module shown in Fig. 1, the optical output of the module can be set to a high optical output of 200 mW.

In other words, on the assumption that a high optical output of 200 mW can be provided by setting the cavity length L of the laser device 3 as the incorporated light emission source to 1000 μm or longer (the equation (1) satisfied), if the reflectivity $R_1$ of the front facet 3A of the laser device 3 and the reflectivity $R_2$ of the fiber Bragg grating 7A are designed in such a way that the effective front facet reflectivity of the module, $R_1 + c^2R_2$, to $0.01\% \leq R_1 + c^2R_2 \leq 4\%$, preferably $0.1\% \leq R_1 + c^2R_2 \leq 4\%$, the maximum optical output (Pmax) of the module can show 200 mW or higher.

The equation (2) that is the essential condition for the module A of the present invention is determined this way.

Note that the coupling efficiency c in the equation (2) represents the optical coupling efficiency between the laser device and the fiber Bragg grating (optical feedback part) and is normally set to lie in the range of $0.75 \leq c \leq 0.9$.

Satisfying both the relationships of the equations (1) and (2) at the same time, the module A of the present invention can be driven as a pumping source which emits a high-power pumping laser beam of 200 mW or higher.

The module B of the present invention will now be discussed.

As the cavity length of the laser device 3 incorporated in the module B satisfies the equation (1), the module B can emit a high optical output. Satisfying the equation (3) at the same time can provide an excellent wavelength stability for the pumping laser beam to be emitted.

That is, even if the center wavelength of the oscillation spectrum of the laser beam emitted from the laser device 3 varies, the module B pulls in and fixes the oscillation spectrum to the vicinity of the center wavelength of the reflection bandwidth $\Delta\lambda$ of the fiber Bragg grating 7A and thus emits a pumping laser beam which does not change the Raman gain when used as a pumping laser beam having an outstanding wavelength stability or a pumping laser beam for Raman amplification.

The following experiment II was conducted to find a condition for pulling the laser beam emitted from the laser device 3 into the vicinity of the center wavelength of the reflection bandwidth $\Delta\lambda$ of the fiber Bragg grating 7A.

Experiment II

Two types of laser devices 3 which had a cavity length L of 1000 μm and whose front facets 3A had reflectivities $R_1$ of 1% and 4% and four types of fiber Bragg gratings 7A which had a reflection bandwidth Δλ of 1.5 nm and had peak reflectivities $R_2$ of 1%, 3%, 5% and 7% were prepared and both components were adequately combined to construct the modules shown in Fig. 1. For the individual modules, the optical output spectra were measured under the same conditions and the ratio (power in band: %) of the optical output to be coupled to the reflection bandwidth Δλ were calculated from the wavelength spectra of the optical outputs based on the following specifications.

As shown in Fig. 6, the spectral curve of the optical output to be acquired has a peak optical output $P_0$ at the position of the center wavelength $\lambda_{FBG}$ in the reflection bandwidth Δλ of the fiber Bragg grating 7A. To begin with, the entire area, $S_0$, under the spectral curve is computed.

Wavelengths $\lambda_1$ and $\lambda_1'$ that provide an optical output, $1/2P_0$, a half of the peak optical output $P_0$, are acquired and an area $S_1$ of the hatched portion in the diagram which lies between the wavelength $\lambda_1$ and the wavelength $\lambda_1'$ is computed. Then, $S_1$ x $100/S_0$ (%) is computed as the "power in band value".

A larger power in band value indicates that even if the center wavelength of the oscillation spectrum of the laser device 3 varies, the oscillation spectrum is pulled into the vicinity of the center wavelength $\lambda_{FBG}$ of the reflection bandwidth Δλ of the fiber Bragg grating 7A so that the wavelength of the pumping laser beam emitted from the module is stable. In other words, the fiber Bragg grating 7A works to effectively realize the pull-in of the laser beam emitted from the laser device 3.

In general, if the value of $S_1$ x $100/S_0$ (%) is equal to or greater than 60%, the pull-in operation is effectively accomplished and the pumping laser beam from the module has an excellent wavelength stability.

A parameter of $R_1/R_2$ was set and the relationship between the power in band value computed in the aforementioned manner and $R_1/R_2$ was acquired in the experiment II. The results are depicted in Fig. 7.

In case of the module whose $R_1/R_2$ is 0.8 or less, as apparent from Fig. 7, the value of $S_1$ x $100/S_0$ is equal to or greater than 60%. That is, it is understood that the module shown in Fig. 1 should be designed in such a way that $R_1/R_2$ becomes 0.8 or less in order to achieve the pull-in of the laser beam from the laser device 3 by the fiber Bragg grating 7A.

The module B was developed in view of the knowledge obtained through the experiment II. As the module incorporates a laser device with a long cavity length, it can emit a high-power pumping laser beam and has a necessary condition to secure the wavelength stability of the pumping laser beam.

The module C of the present invention satisfies all of the equations (1), (2) and (3). Because the module C has a high power optical output of 200 mW or greater and a capability of surely emitting a pumping laser beam with an excellent wavelength stability, the module C is useful as a pumping source when the Raman amplification system is adapted.

The relationship between $R_1$ and $R_2$ defined in the equations (2) and (3) is shown in Fig. 8. The module C that simultaneously fulfills the equations (2) and (3) can be assembled when the values of $R_1$ and $R_2$ satisfy any value lying in the hatched area in Fig. 8.

In this case, the value of $R_1 + c^2R_2$ given in the equation (2) varies depending on the value of the coupling efficiency c as c is a variable.

Therefore, the proper $R_1$ and $R_2$ have only to be selected in Fig. 8 in association with the efficiency (c) of coupling between the laser device 3 and the fiber Bragg grating 7A as a designed value of the laser module to be fabricated.

As shown in Fig. 5 showing the results of the experiment I, the maximum optical output Pmax of the laser device 3 incorporated in the module varies depending on the level of the reflectivity $R_1$ of the front facet 3A and the size of the cavity length L. In case where the laser device 3 has a cavity length L of 1300 μm, for example, Pmax shows a high value of 350 to 400 mW when the reflectivity $R_1$ of the front facet 3A is 0.6 to 2%. In case where the laser device 3 has a cavity length L of 1500 μm, Pmax shows a high value of 400 to 470 mW when the reflectivity $R_1$ of the front facet 3A is 0.14 to 1.7%. That is, to acquire a high optical output as the cavity length L is made longer, the reflectivity $R_1$ of the front facet of the laser device should be made lower, as apparent from Fig. 5.

Therefore, in case where the laser device 3 incorporated in the module C has a long cavity length L, the value of $R_1 + c^2R_2$ should be made small, whereas in case where the laser device 3 has a short cavity length L, the value of $R_1 + c^2R_2$ should be made large.

In case where the center wavelength of the oscillation spectrum of the pumping laser beam from the laser device 3 in the any of the modules A, B and C is pulled into the vicinity of the center wavelength of the reflection bandwidth Δλ of the fiber Bragg grating 7A, the oscillation spectral width of the laser device 3 is included in the reflection bandwidth of the fiber Bragg grating 7A.

In consideration of the conditions that the oscillation spectral width of the laser device 3 is set to 3 nm or less, preferably 2 nm or less, in order to reduce the degree of polarization of the pumping laser beam from the module, suppress the generation of a kink and acquire a pumping laser beam of multi-mode which can restrain a variation in Raman gain, it is preferable to set the reflection bandwidth $\Delta\lambda$ of the fiber Bragg grating 7A to 3 nm or less. If $\Delta\lambda$ is made too narrow, however, the center wavelength cannot be pulled into the reflection bandwidth of the fiber Bragg grating 7A. It is therefore preferable that $\Delta\lambda$ should lie in the range of $0.2\ nm \leq \Delta\lambda \leq 3\ nm$.

With regard to the reflection bandwidth $\Delta\lambda$ and peak reflectivity $R_2$ of the fiber Bragg grating 7A, the following experiment III was conducted.

Experiment III

Prepared was a laser device which had a cavity length L of 1300 μm and whose front facet 3A had a peak reflectivity of 1.2% and whose oscillation spectrum had a center wavelength of 1480 nm. Also prepared were the fiber Bragg gratings whose peak reflectivities $R_2$ and reflection bandwidths $\Delta\lambda$ had values given in Table 1. Fifteen modules were assembled by combining the laser device and the fiber Bragg gratings, their optical output v.s. current characteristics were measured and it was checked whether or not a kink occurred. The results are shown as the relationship between the peak reflectivity $R_2$ and the reflection bandwidth $\Delta\lambda$ in Table 1.

Note that the mark ○ in Table 1 means the generation of no kink up to the maximum driving current, the mark Δ means the generation of a small kink and the mark X means the generation of a large kink.

Table 1

| | | $\Delta\lambda$ (nm) | | | | |
|---|---|---|---|---|---|---|
| | | 0.5 | 1.0 | 1.5 | 2.0 | 3.0 |
| $R_2$ (%) | 1 | × | ○ | ○ | ○ | Δ |
| | 5 | not measured | ○ | ○ | ○ | not measured |
| | 7 | × | Δ | Δ | Δ | × |

As apparent from Table 1, the reflection bandwidth $\Delta\lambda$ and the peak reflectivity $R_2$ should be combined adequately in order to suppress the generation of a kink. Generally speaking, the use of the fiber Bragg grating whose peak reflectivity $R_2$ is 7% or less and whose reflection bandwidth $\Delta\lambda$ is 3 nm or narrower can allow the assembled module to suppress the generation of a kink.

In view of the above, it is desirable to set the reflection bandwidth $\Delta\lambda$ of the fiber Bragg grating 7A to 3 nm or narrower, preferably 2 nm or narrower.

Examples

Two kinds of laser devices 3 were fabricated by forming a laminated structure in Fig. 3 on the substrate using a GaInAsP-based semiconductor material, then cleaving the structure so that the cavity length became 1300 μm and 1500 μm, forming a high-reflectivity film of a reflectivity of 95% on one cleaved face to form the rear facet 3B and forming a low-reflectivity film of a reflectivity of 1.2% on the other cleaved face to form the front facet 3A. Those laser devices emit laser beams with an oscillation spectrum having a center wavelength of 1480 nm.

The specifications of the laser devices are shown in Table 2.

Table 2

| | | Laser Device a | Laser Device b |
|---|---|---|---|
| Cavity length (L: μm) | | 1300 | 1500 |
| Reflectivity (%) | rear facet | 95 | 95 |
| | front facet ($R_1$) | 0.1 | 0.1 |
| Center wavelength of oscillation spectrum (nm) | | 1480 | 1480 |

Then, the modules shown in Fig. 1 were assembled by optically coupling the front facet 3A of each laser device to the end face of the optical fiber 7 having the fiber Bragg grating 7A formed therein. The coupling efficiency c was 0.76 for the module with L = 1300 μm and 0.85 for the module with L = 1500 μm.

In consideration of the results of the experiment I given in Fig. 5 such that the reflectivity $R_1$ of the front facet 3A which would provide a peak in the curve of the maximum optical output Pmax of the laser device having the cavity length L of 1300 µm was about 1.2% and the reflectivity $R_1$ of the front facet 3A in the case of the laser device having the cavity length L of 1500 µm was about 0.5%, the fiber Bragg gratings were selected in both the cases where the effective reflectivities of the module using the laser device a and the module using the laser device b respectively became 1.2% and 0.5%.

Specifically, the optical fiber 7 having the fiber Bragg grating 7A having a reflection bandwidth $\Delta\lambda$ of 1.5 nm and a peak reflectivity $R_2$ of 1.91% was selected for the module (Example 1) using the laser device a and the optical fiber 7 having the fiber Bragg grating 7A having a reflection bandwidth $\Delta\lambda$ of 1.5 nm and a peak reflectivity $R_2$ of 0.55% was selected for the module (Example 2) using the laser device b.

The values of the equations (1), (2) and (3) for the assembled two modules are given in Table 3.

Table 3

| Conditions | Example 1 | Example 2 |
|---|---|---|
| Equation (1): L (µm) | 1300 | 1500 |
| Equation (2): $R_1 + c^2R_2$ (%) | 1.2 | 0.5 |
| Equation (3): $R_1/R_2$ | 0.052 | 0.182 |
| Wavelength bandwidth of fiber Bragg grating ($\Delta\lambda$: nm) | 1.5 | 1.5 |

As apparent from Table 3, each of the modules of Examples 1 and 2 is the module C of the present invention.

The two modules were driven and their current v.s. optical output characteristics were acquired. The results are shown in Fig. 9.

As apparent from Fig. 9, the modules of Examples 1 and 2 both have Pmax of 280 mW or greater and emit high-power optical outputs. As apparent from Fig. 9, no kink has occurred in the area where the driving current that provides Pmax is equal to or smaller than 1300 mA for Example 1 and 2000 mA for Example 2.

As apparent from the foregoing description, the modules of the present invention have the following advantages.

(1) The module A operates with a high optical output of 300 mW or greater as the cavity length L of the incorporated laser device satisfies the equation (1) and the equation (2) is met.

(2) Because the module B has the condition for the equation (3) in addition to the condition for the equation (1), the module B can operate with a high optical output and the pumping laser beam to be emitted has an excellent wavelength stability.

(3) Because the module C satisfies all the equations (1), (2) and (3) at the same time, the module C can emit a pumping laser beam having a high optical output of 300 mW or greater and an excellent wavelength stability. The module C is therefore useful as a pumping source of the WDM communications system to which the Raman amplification system is adapted.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

**1.** A semiconductor laser module comprising:

a Fabry-Pérot semiconductor laser device to which an optical feedback part having a wavelength selectivity and showing a specific reflectivity with respect to a specific wavelength is optically coupled,

wherein given that a cavity length of said semiconductor laser device is L (unit: µm), a reflectivity of said front facet is $R_1$ (%) and a peak reflectivity of said optical feedback part is $R_2$ (%), following equations are satisfied among L, $R_1$ and $R_2$

$$1000\ \mu m \leq L \leq 3500\ \mu m$$

and

$$0.01\% \leq R_1 + c^2R_2 \leq 4\%$$

where c represents a coupling efficiency between said semiconductor laser device and said optical feedback part.

**2.** The semiconductor laser module according to claim 1, wherein the reflectivity $R_1$ and the peak reflectivity $R_2$ satisfy an expression:

$$0.1\% \leq R_1 + c^2R_2 \leq 4\%$$

**3.** A semiconductor laser module comprising:

a Fabry-Pérot semiconductor laser device to which an optical feedback part having a wavelength selectivity and showing a specific reflectivity with respect to a specific wavelength is optically coupled,

wherein given that a cavity length of said semiconductor laser device is L (unit: µm), a reflectivity of said front facet is $R_1$ (%) and a peak reflectivity of said optical feedback part is $R_2$ (%), following equations are satisfied among L, $R_1$ and $R_2$

$$1000\ \mu m \leq L \leq 3500\ \mu m$$

and

$$R_1/R_2 \leq 0.8.$$

**4.** A semiconductor laser module comprising:

a Fabry-Pérot semiconductor laser device to which an optical feedback part having a wavelength selectivity and showing a specific reflectivity with respect to a specific wavelength is optically coupled,

wherein given that a cavity length of said semiconductor laser device is L (unit: µm), a reflectivity of said front facet is $R_1$ (%) and a peak reflectivity of said optical feedback part is $R_2$ (%), following equations are satisfied among L, $R_1$ and $R_2$

$$1000\ \mu m \leq L \leq 3500\ \mu m,$$

$$0.01\% \leq R_1 + c^2R_2 \leq 4\%$$

and

$$R_1/R_2 \leq 0.8$$

where c represents a coupling efficiency between said semiconductor laser device and said optical feedback part.

**5.** The semiconductor laser module according to claim 4, wherein the reflectivity $R_1$ and the peak reflectivity $R_2$ satisfy following expressions:

$$0.1\% \leq R_1 + c^2R_2 \leq 4\%$$

and

$$R_1/R_2 \leq 0.8.$$

**6.** The semiconductor laser module according to any one of claims 1 to 5, wherein a reflection bandwidth ($\Delta\lambda$) of said optical feedback part meets a following equation:

$$0.2 \text{ nm} \leq \Delta\lambda \leq 3 \text{ nm}.$$

**7.** The semiconductor laser module according to any one of claims 1 to 6, wherein said optical feedback part is a fiber Bragg grating.

**8.** A fiber optical amplifier comprising:

a semiconductor laser module as set forth in any one of claims 1 to 7 is used as a pumping source.

**9.** An optical communications system comprising:

a semiconductor laser module as set forth in any one of claims 1 to 7; and
a fiber optical amplifier as set forth in claim 8.

FIG. 1

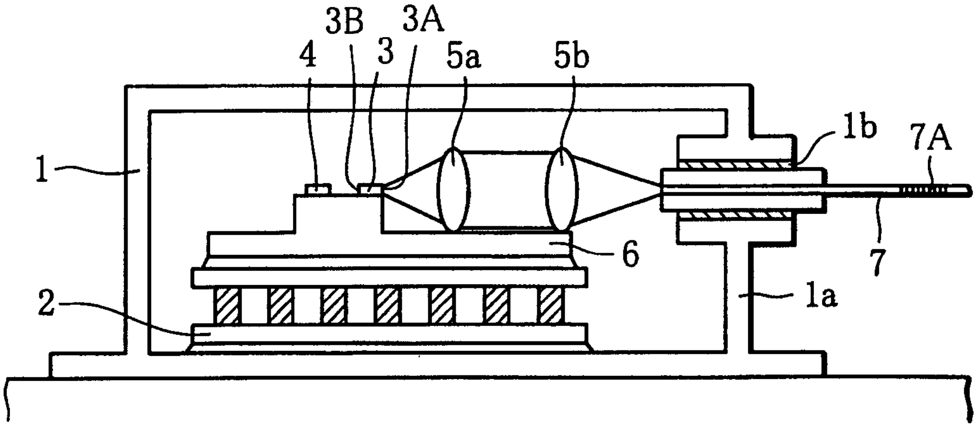


FIG. 2

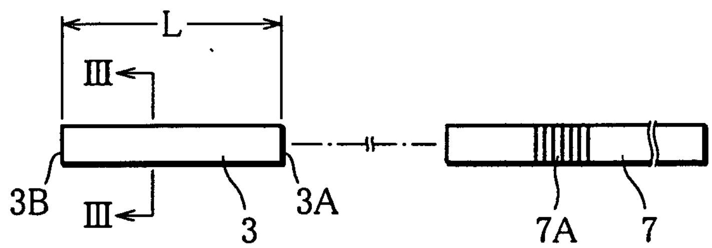


FIG. 3

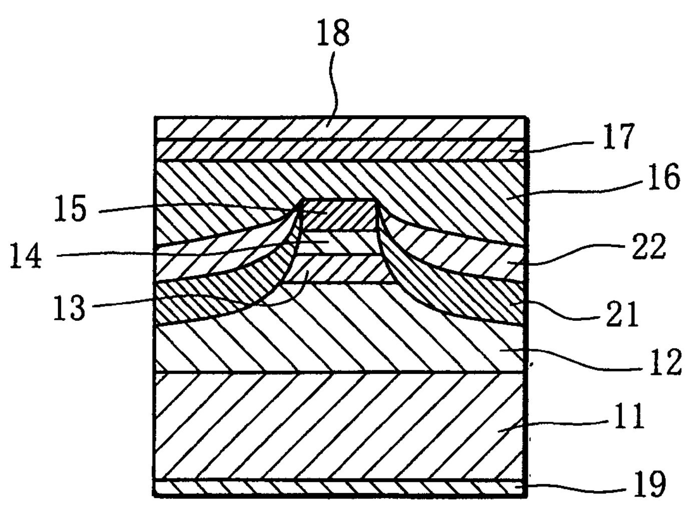

FIG. 4

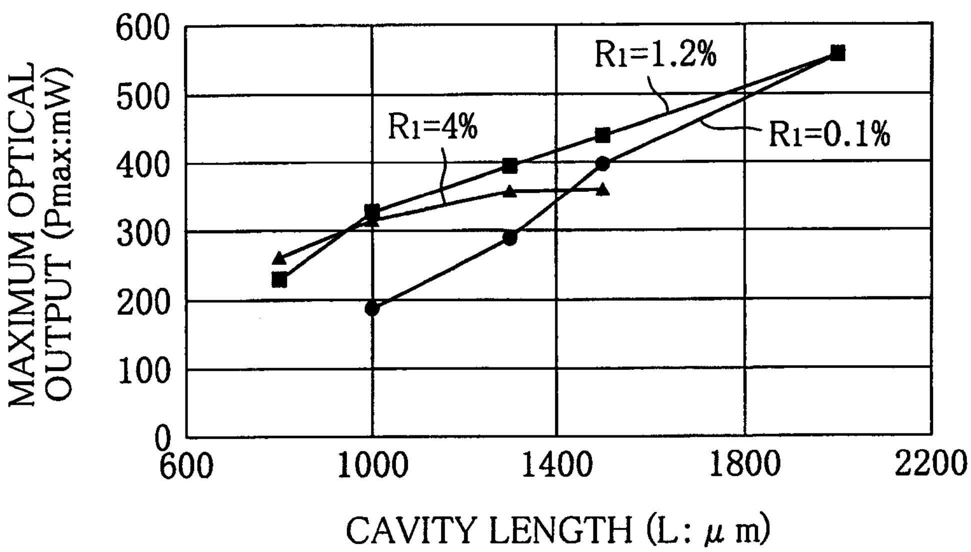
MAXIMUM OPTICAL OUTPUT (Pmax:mW)
600
500
400
300
200
100
0
600
1000
1400
1800
2200
CAVITY LENGTH (L: μ m)
R1=1.2%
R1=4%
R1=0.1%

FIG. 5

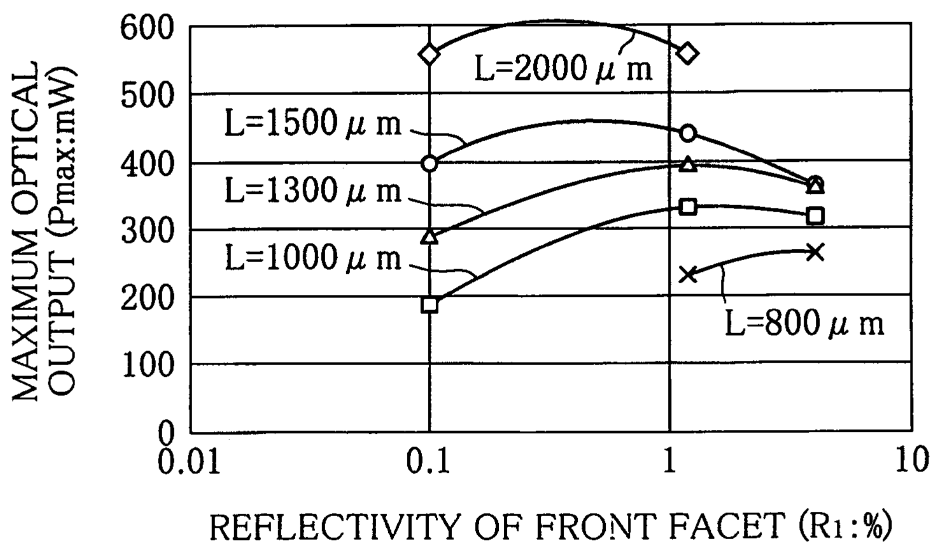
MAXIMUM OPTICAL OUTPUT (Pmax:mW)
600
500
400
300
200
100
0
0.01
0.1
1
10
REFLECTIVITY OF FRONT FACET (R1:%)
L=2000 μ m
L=1500 μ m
L=1300 μ m
L=1000 μ m
L=800 μ m

FIG. 6

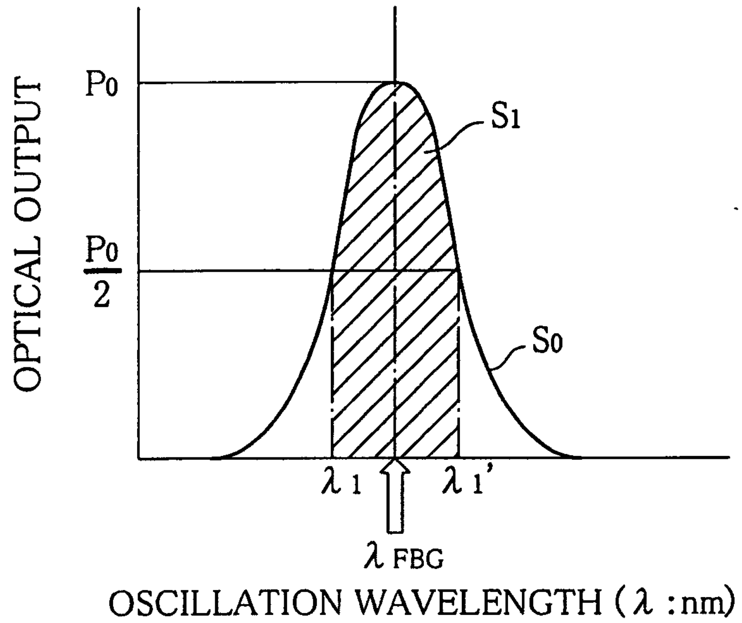
OPTICAL OUTPUT
P0
P0/2
S1
S0
λ1
λ1'
λFBG
OSCILLATION WAVELENGTH (λ :nm)

FIG. 7

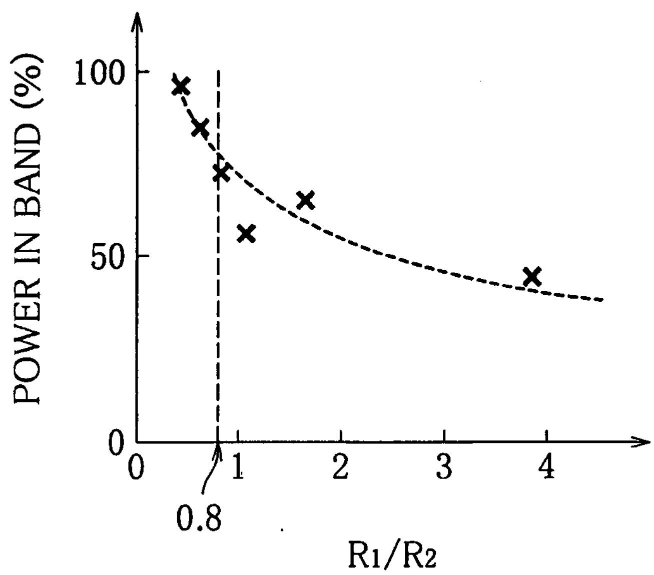
POWER IN BAND (%)
100
50
0
0
1
2
3
4
0.8
R1/R2

# FIG. 8

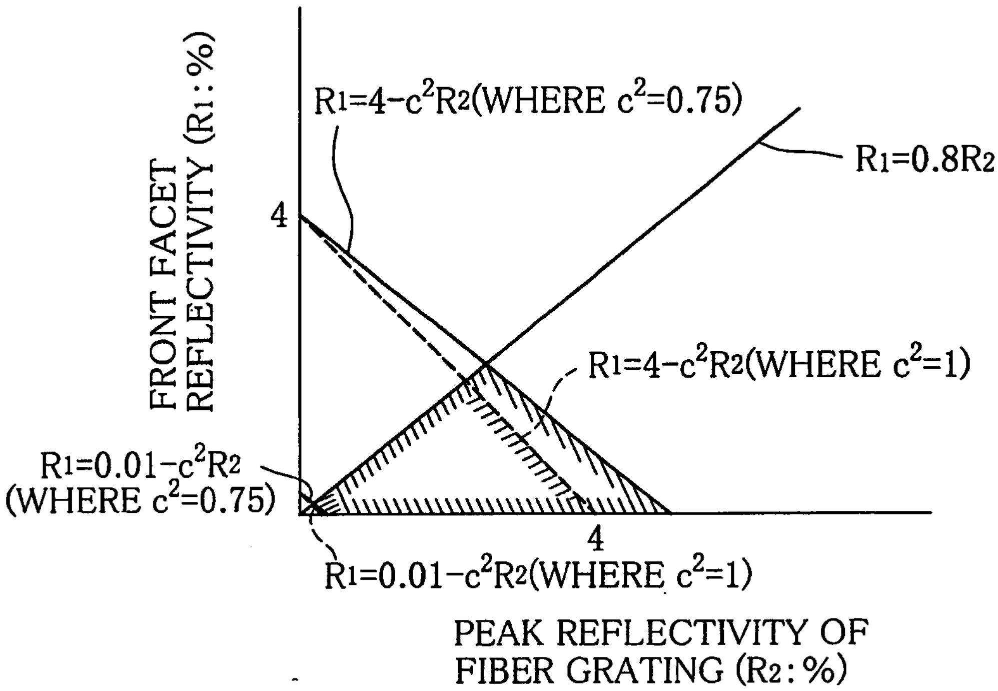
FRONT FACET REFLECTIVITY (R1 : %)
4
R1=4−c2R2(WHERE c2=0.75)
R1=0.8R2
R1=4−c2R2(WHERE c2=1)
R1=0.01−c2R2 (WHERE c2=0.75)
4
R1=0.01−c2R2(WHERE c2=1)
PEAK REFLECTIVITY OF FIBER GRATING (R2 : %)

# FIG. 9

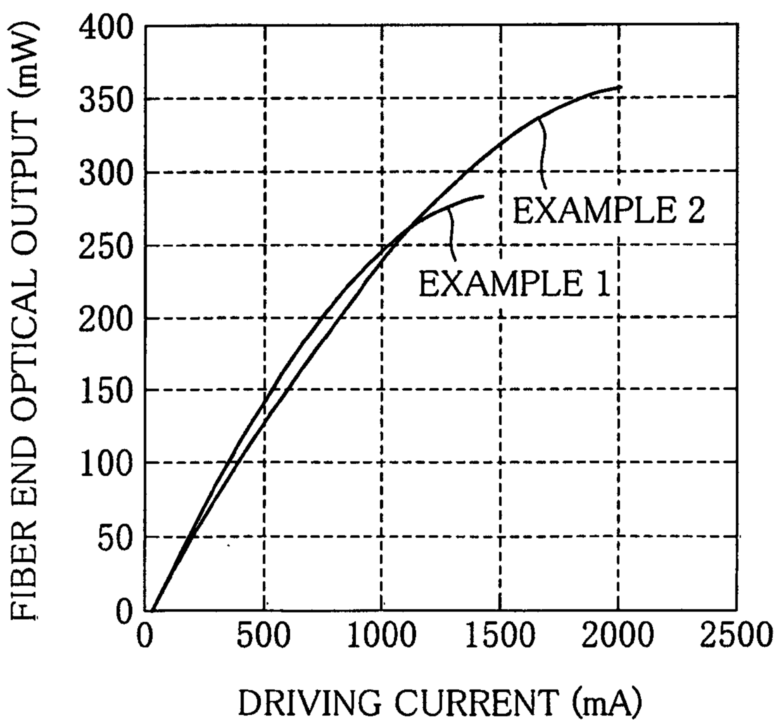
FIBER END OPTICAL OUTPUT (mW)
400
350
300
250
200
150
100
50
0
0
500
1000
1500
2000
2500
EXAMPLE 2
EXAMPLE 1
DRIVING CURRENT (mA)